# EUROPÄISCHE PATENTSCHRIFT

(11) **EP 1 508 176 B1**
(45) Veröffentlichungstag und Bekanntmachung des Hinweises auf die Patenterteilung: **09.08.2006**
(21) Anmeldenummer: 03740015.7
(22) Anmeldetag: 22.05.2003
(51) Int. Cl.: H01L 51/50

(54) **PHOSPHORESZENTES LICHTEMITTIERENDES BAUELEMENT MIT ORGANISCHEN SCHICHTEN**
PHOSPHORESCENT LIGHT-EMITTING COMPONENT COMPRISING ORGANIC LAYERS
COMPOSANT ELECTROLUMINESCENT PHOSPHORESCENT DOTE DE COUCHES ORGANIQUES

(30) Priorität: 24.05.2002 DE 10224021
(43) Veröffentlichungstag der Anmeldung: 23.02.2005
(73) Patentinhaber: Novaled GmbH, 01307 Dresden (DE)
(72) Erfinder: DASHAN, Qin, Inst. for Microstructural Sciences, Ottawa, Ontario K1A 0R6 (CA); ZHOU, Xiang, State Key Lab of Optoel. Mat. & Tech., Zhongshan 510275 (CN); BLOCHWITZ-NIMOTH, Jan, 01069 Dresden (DE); PFEIFFER, Martin, 01139 Dresden (DE)
(74) Vertreter: Bittner, Thomas L.
(86) Internationale Anmeldenummer: PCT/DE2003/001659
(87) Internationale Veröffentlichungsnummer: WO 2003/100880

(56) Entgegenhaltungen:
- WO-A-01/08230
- WO-A-02/41414
- US-A1- 2003 146 443
- WENPING HU ET AL: "Efficient red electroluminescence from devices having multilayers of a europium complex" APPL. PHYS. LETT. (USA), APPLIED PHYSICS LETTERS, AIP, USA, Bd. 77, Nr. 26, 25. Dezember 2000 (2000-12-25), Seiten 4271-4273, XP002286717 ISSN: 0003-6951 in der Anmeldung erwähnt
- ADACHI C ET AL: "HIGH-EFFICIENCY ORGANIC ELECTROPHORESCENT DEVICES WITH TRIS(2-PHENYLPYRIDINE)IRIDIUM DOPED INTO ELECTRON-TRANSPORTING MATERIALS" APPLIED PHYSICS LETTERS, AMERICAN INSTITUTE OF PHYSICS. NEW YORK, US, Bd. 77, Nr. 6, 7. August 2000 (2000-08-07), Seiten 904-906, XP000956860 ISSN: 0003-6951 in der Anmeldung erwähnt
- IKAI M ET AL: "HIGHLY EFFICIENT PHOSPHORESCENCE FROM ORGANIC LIGHT-EMITTING DEVICES WITH AN EXCITON-BLOCK LAYER" APPLIED PHYSICS LETTERS, AMERICAN INSTITUTE OF PHYSICS. NEW YORK, US, Bd. 79, Nr. 2, 9. Juli 2001 (2001-07-09), Seiten 156-158, XP001075381 ISSN: 0003-6951 in der Anmeldung erwähnt

## Beschreibung

Die Erfindung bezieht sich auf ein lichtemittierendes Bauelement mit organischen Schichten, insbesondere eine organische Leuchtdiode (OLED).

### Hintergrund der Erfindung

Organische Leuchtdioden sind seit der Demonstration niedriger Arbeitsspannungen von Tang et al. 1987 (C.W. Tang et al. Appl. Phys. Lett. 51 (1987) 913) aussichtsreiche Kandidaten für die Realisierung großflächiger Displays. Sie bestehen aus einer Folge dünner (typischerweise 1nm bis 1µm) Schichten aus organischen Materialien, welche bevorzugt im Vakuum aufgedampft (kleine Moleküle OLEDs) oder aus der Lösung z. B. durch Schleudern aufgebracht (polymere OLEDs = PLEDs) werden. Nach elektrischer Kontaktierung durch Metallschichten bilden organische Dünnschichten vielfältige elektronische oder optoelektronische Bauelemente, wie z. B. Dioden, Leuchtdioden, Photodioden und Transistoren, die mit ihren Eigenschaften den etablierten Bauelementen auf der Basis anorganischer Schichten Konkurrenz machen. Die Kontakte lichtemittierender Bauelemente sind typischerweise ein transparenter Kontakt (z. B. Indium-Zinn-Oxid - ITO als Anode) und ein metallischer Kontakt mit einer niedrigen Austrittsarbeit als Kathode. Andere OLEDs sind semitransparent (dünner Metall Kontakt - ITO Struktur) andere voll transparent (beide Kontakte ITO). Damit Licht von der aktiven Zone im Bauelement emittiert werden kann (die Emissionszone bzw. die Emissionsschicht bzw. -schichtreihenfolge) müssen Ladungsträger in das Bauelement injiziert werden und innerhalb der organischen Schichten transportiert werden. Mittels einer angelegten Spannung werden Löcher von der Anode in ein organisches Material mit besserer Löcherleitfähigkeit (Löchertransportmaterial) und Elektronen von der Kathode in ein elektronenleitendes Material injiziert. Die Ladungsträger treffen sich in der Emissionszone, dort rekombinieren sie und bilden Exzitonen. Diese zerfallen später unter Lichtaussendung oder Abgabe ihrer Energie an die Moleküle.

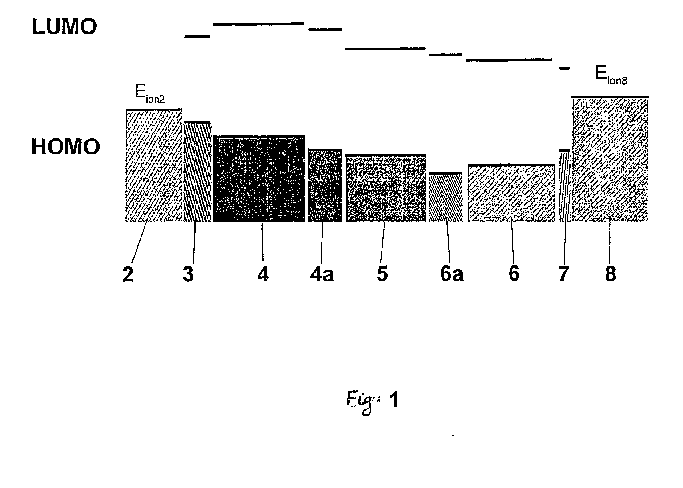

Die Vorteile einer solchen LED auf Basis organischer Moleküle verglichen mit den seit langem bekannten anorganischen LEDs sind die Möglichkeiten, organische Materialien auf große, potentiell flexible Flächen aufzutragen. Dadurch können sehr große Displays hergestellt werden. Ausserdem sind die org. Materialien relativ preiswert in ihrer Produktion und der Herstellung der organischen Schichten. Weil sie außerdem einen niedrigen Brechungsindex aufweisen, kann das erzeugte Licht einfach (mit hoher Effizienz) ausgekoppelt werden. Die normale Struktur einer OLED enthält einige oder alle der folgenden organischen Schichten (vgl. Fig. 1):
1. Substrat,
2. Grundelektrode, z. B. löcherinjizierend (Anode), typischerweise transparent,
3. Löcher injizierende Schicht,
4. Löcher transportierende Schicht (HTL),
4a. evtl. Blockschicht, löcherseitig,
5. Licht emittierende Schicht (EL),
6a. evtl. Blockschicht, elektronenseitig,
6. Elektronen-Transportschicht (ETL),
7. Elektronen injizierende Schicht,
8. Deckelektrode, meist ein Metall mit niedriger Austrittsarbeit, Elektronen injizierende (Kathode),
9. Kapselung, um Umwelteinflüsse (Luft, Wasser) auszuschließen.

Dies ist der allgemeinste Fall, meistens werden einige Schichten weggelassen (außer 2., 5. und 8.), oder aber eine Schicht kombiniert in sich mehrere Eigenschaften. Im oben beschriebenen Bauelement verläßt das Licht die OLED durch die transparente Basiselektrode. Andere Strukturen wurden demonstriert, bei denen die Schichtstruktur invertiert ist (Anode oben, Lichtemission durch Kathode und Substrat) (G. Gu, V. Bulovic, P.E. Burrows, S.R. Forrest, Appl. Phys. Lett., 68, 2606 (1996), US 5,703,436; US 5,757,026; US 5,969,474) oder durch Anode und Kathode.

Wie bei Egusa et al. (US 5,093,698) und Pfeiffer et al. (DE 100 58 578.7) beschrieben, können die Ladungstransportschichten (3 und 4, bzw. 6 und 7) dotiert sein, um ihre Leitfähigkeit zu erhöhen. Um dann die Strom und Quanteneffizienz (Stromeffizienz = Lichtemission pro Strom - cd/A - Quanteneffizienz = emittierte Photonen pro injizierten Ladungsträger) hoch zu halten werden Blockschichten (4a, 6a) benötigt. Diese verhindern eine Bildung von Exzitonen (DE 100 58 578.7). Diese Blockschichten haben zwei wichtige Aufgaben zu erfüllen:
1. Sie müssen die Injektion von Minoritätsladungsträgern von der Emissionszone (5) in die Ladungsträgertransportschichten (Elektronen in 4, Löcher in 6) verhindern. In den meisten Fällen erfüllen die Ladungsträgertransportschichten (4,6) bereits diese Forderung. Dann ist die zweite Eigenschaft der Blockschichten wichtig:
2. Sie müssen Exziplexbildung zwischen Majoritätsladungsträgern in den Ladungsträgertransportschichten (Löcher in 4, bzw. Elektronen in 6) und Ladungsträger mit unterschiedlichem Vorzeichen in der Emissionszone (5) an der Grenzfläche zwischen der Emissionschicht und der jeweiligen Ladungsträgertransportschicht verhindern. Diese Exziplexe, welche nichtstrahlend rekombinieren und somit die Effizienz der OLED verringern, werden gebildet, wenn die Exziplexenergie geringer ist, als die Energie eines Exzitons in der Emissionszone. In diesem Fall kann der Exziplex nicht in ein Exziton in der Emissionszone umgewandelt werden. Die Ursache dieses Verhaltens ist eine zu hohe Barriere für die Majoritätsladungsträger aus den Transportschichten (4, bzw. 6) in die Emissionszone (5). Diese Barriere wird bestimmt durch die HOMO (Energie des höchsten besetzten Molekülorbitals) Differenz für Löcherinjektion von ihrer Transportschicht (4) in die Emissionszone (5) und die LUMO (Energie des niedrigsten unbesetzten Molekülorbitals) Differenz von 6 in Schicht/en 5. Dieser Prozess kann durch die Wahl geeigneter Blockschichten (4a, 6a) verhindert werden. Diese müssen hinsichtlich ihrer HOMO / LUMO Lagen so angepasst werden, dass sie Minoritätsladungsträger am Verlassen der Emissionszone behindern können. Das heisst, dass unter angelegter Spannung die Majoritätsladungsträger in den Transportschichten (4, 6) nicht zu sehr an der Injektion in die Blockschichten (4a, 6a) gehindert werden - mittlere Barriere. Gleichzeitig müssen die Minoritätsladungsträger aus der Emissionszone (5) an der Grenzfläche zu den Blockschichten (Elektronen an 4a, Löcher an 6a)) effizient geblockt werden - hohe Barriere. Zusätzlich muss die Barrierenhöhe für Majoritätsladungsträgerinjektion von den Blockschichten (4a, 6a) in die Emissionzonenschichten (5) klein genug sein, um Exziplexbildung zu verhindern - kleine Barriere.

Im einfachsten Fall besteht die Emissionszone (5) nur aus einer Schicht (US 4,356,429; C.W. Tang et al. Appl. Phys. Lett. 51 (1987) 913). Diese Schicht kombiniert dann Elektronen- und Löchertransport, Exiztonenbildung und Zerfall. Diese vielfältigen Anforderungen machen es schwer, geeignete Materialien zu finden, um die Effizienz zu optimieren. Beispielsweise ist das Standard-Emitter-Material Alq₃ (aluminium-tris-quinolate, HOMO=-5,7eV, LUMO=-2,9eV) ein relativ guter Elektronentransporter. Es hat eine große Stokesverschiebung (Emission rotverschoben gegenüber der Absorption, daher keine Re-Absorption), aber eine schlechte Löcherleitfähigket. Daher findet die Exzitonenbildung in einem Bauelement mit Alq₃ als Emittermaterial nahe der Grenzfläche zur Löchertransportschicht (4 oder 4a) statt. Die Auswahl dieser Grenzfläche ist dann extrem wichtig für die Effizienz der OLED. Das ist die Ursache, warum für OLEDs der Effekt der Grenzflächenrekombination wichtiger ist als für anorganische LEDs: Weil der Ladungsträgertransport in organischen Schichten oft auf eine Ladungsträgersorte limitiert ist und die Ladungsträger auf den organischen Molekülen stärker lokalisiert sind als im anorganischen Fall ist die Rekombinationszone (wo ein großer Überlapp zwischen den Ladungsträgerdichten beider Ladungsträgersorten besteht) meist nahe einer internen Grenzfläche, wo Ladungsträger geblockt werden.

Die Photolumineszenzquantenausbeute (der Anteil der strahlend rekombinierenden Exzitonen) ist bei allen organischen Materialien limitiert durch das sog. "aggregate quenching", der verringerten Effizienz der Lichtaussendung wenn die Moleküle eng gepackt vorliegen. Die Photolumineszenzquantenausbeute einer reinen Alq₃-Schicht liegt daher zwischen 10 und 25% (C.W. Tang et al. J. Appl. Phys. 65 (1989) 3610; H. Mattoussi et al. J. Appl. Phys. 86 (1999) 2642), niedriger als für Alq₃ in der Lösung (>50%).

Daher wird der Emissionszone oft ein zusätzliches Emitter-Molekül beigemischt (in der Literatur auch oft als Dotierung bezeichnet, aber von der oben erwähnten Dotierung zur Erhöhung der Leitfähigkeit zu unterscheiden) (US 4,769,292; C.W. Tang et al. J. Appl. Phys. 65 (1989) 3610). Das hat den Vorteil, dass der Emitter nicht mehr konzentriert vorliegt und eine höhere Quantenausbeute der Lichtemission aufweist. Photolumineszenzquantenausbeuten bis zu 100% werden beobachtet (H. Mattoussi et al. J. Appl. Phys. 86 (1999) 2642). Die Emitter-Dotanden nehmen nicht am Ladungsträgertransport teil. Die Exzitonenbildung auf den Emitter-Dotanden kann auf zwei Wegen erfolgen:
1. Entweder direkt auf dem Emitter-Molekül, wenn dieses als Ladungsträgerfalle (-trap) wirkt,
2. oder via Energieübertrag von den Wirtsmolekülen.

Auf diese Weise kann die Strom- und Quanteneffizienz einer OLED erhöht werden, von z. B. typischerweise 5 cd/A für OLEDs mit reinem Alq₃ als Emitter bis auf 10 cd/A (J. Blochwitz et al. Synth. Met. 127 (2002) 169) mit einem Emitterdotanden, der von Singulett-ExzitonenZuständen emittiert. (z. B. einem Quinacridon oder einem Laser-Farbstoff, wie Coumarin, z. B. Coumarin6 HOMO=-5,4eV, LUMO=-2,7eV). Die Konzentration liegt typischerweise bei 1 mol-%. Für oben erwähnte Singulett-Exzitonen, die einen Spin von 0 aufweisen und bei bipolarer Ladungsträgerinjektion nur zu ca. 25% gebildet werden, findet der Energieübertrag über einen sog. Förster-Prozess statt. Die Reichweite dieses Prozesses entspricht ungefähr der Dotierungskonzentration von 1%.

Ein weiterer Weg, um die Effizienz der OLEDs zu erhöhen, ist die Beimischung von Molekülen, welche in der Lage sind von Triplett-Zuständen (Exzitonenspin=1) zu emittieren (Moleküle mit starker Spin-Bahn Kopplung) (US 6,303,238 B1). Diese werden mit ca. 75% Wahrscheinlichkeit gebildet. Für spezielle Materialien die Singulett und Triplett Zustände mischen sind daher theoretisch 100% interne Effizienz der OLED möglich (T. Tsutsui et al. Jpn.J. Appl. Phys. B 38 (1999) L1502; C. Adachi et al. Appl. Phys. Lett. 77 (2000), 904). Jedoch haben Triplett-Exzitonen auf org. Molekülen einige Nachteile gegenüber Singulett-Exzitonen:
1. Die Triplett-Exzitonen Lebensdauer ist lang und daher auch ihre Diffusionslänge. Daher können Triplett-Exzitonen leichter Plätze im Bauelement (wie Störstellen, Fremdstoffe, Kontakte) erreichen, wo sie nicht-strahlend rekombinieren. Wegen ihrer langen Lebensdauer (typischerweise über 100mal länger als Singulett-Exzitonen) erreicht die Exzitonendichte Werte, wo Exziton-Exziton-Vernichtung ein Rolle spielt. Dieser Prozess limitiert die Effizienz vor allem bei hohen Stromdichten (M.A. Baldo et al. Appl. Phys. Lett. 75 (1999) 4, C. Adachi et al. Appl. Phys. Lett. 77 (2000), 904).
2. Der Energietransfer ist langsamer und hat eine kürzere Reichweite (Dexter-Prozess). Daher müssen die Dotierkonzentrationen bei Beimischung von Emittermolekülen bei ca. 8 mol.-% liegen. Diese hohe Dichte an elektrischen Traps behindert denn Stromtransport und "Aggregate Quenching" ist ein stärkeres Problem als bei Singulett-Exzitonen-Emittem.
3. Aufgrund der langen Triplett-Exzitonen-Lebensdauer kann die Dichte an Triplett-Exzitonen an Grenzflächen einen hohen Wert annehmen. Daher kann es zu Triplett-Exzitonen-Sättigung kommen. Dieser "Grenzflächen-Exzitonen Sättigungs-Prozess" verringert die Bildung weiterer Exzitonen aus ankommenden Ladungsträgern, weshalb diese die Überlapp-Zone verlassen können. Deshalb hat die Grenzflächenzone nur eine limitierte Kapazität für Exzitonen, obwohl die Bildung von Exzitonen dort am effizientesten erfolgen kann. Die Effizienz der OLED ist daher verringert.
4. Die Triplett-Exziton Bindungsenergie ist größer als die für Singulett-Exzitonen (bis 1.5eV verglichen zu ungefähr 0.5eV). Daher ist ein Energieübertrag von einem Grenzflächen-Ladungsträgerpaar mit Spin=1 ("Triplett Exziplex", eine Ladungsträger auf dem Material der Emissionszone (5), das andere auf der angrenzenden Schicht z. B. 4, bzw. 4a für ein Loch, 6, bzw. 6a für ein Elektron) zu einem Schicht-Exziton auf beiden Schichten, entweder auf dem Material der Emissionzone (5) oder auf dem Material der jeweils angrenzenden Transportschichten (4, bzw. 4a, 6, bzw. 6a) möglich. Das auf den Transportschichten erzeugte Triplett-Exziton wird nichtstrahlend rekombinieren, verringert also die OLED-Effizienz. Im Gegensatz zu Singulett-Exzitonen ist dieser Prozess für Triplett-Exzitonen möglich, auch wenn eine hohe Barriere für Ladungsträgerinjektion (in die Schichten 4, 4a, 6, 6a) existiert.

Die Bedeutung von Blockschichten für die Effizienz von Triplett-OLEDs wurde von Adachi et al. und Ikai et al. gezeigt (C. Adachi et al. Appl. Phys. Lett. 77 (2000), 904) und M. Ikai et al. (M. Ikai et al. Appl. Phys. Lett. 79 (2001) 156). Ersterer zeigte, daß Exziton "confinement" (Eingrenzung) der Exzitonen in der Emissionszone (durch größere Bandlücken der umgebenden Schichten) zu einer sehr hohen Quanteneffizienz auch bei geringer Dicke der Emissionszone führen kann (bis 2.5nm dünn). Ohne Exziton Blockierung verringerte sich die Effizienz drastisch bei so niedrigen Dicken. Bei einer geringen Dicke der Emissionsschicht spielt aber Triplett-Triplett-Vernichtung eine größere Rolle und minimiert die Effizienz bei hohen Stromdichten. Der Zweite (Ikai et al.) verwendete ein Löchertransportierendes Wirtsmaterial für den Triplett-Emitter-Dotanden Ir(ppy)₃ als Gastmolekül (Ir(ppy)₃ - fac-tris(2-phenylpyridine, HOMO=-5,2..-5,6eV, LUMO=-2,8..-3,0eV - bester bekannter Triplett Emitter für den grünen Spektralbereich). Ausserdem setzte er einen sehr effizienten Exzitonen- und Löcherblocker (hohe Bandlücke und niedriges HOMO) ein. Das erlaubte extrem hohe Quanteneffizienzen bis nahe an das theoretische Limit von 20% (Limit abgeschätzt aus einfachen Strahlenoptikberechnungen über das Auskoppelverhalten des Lichtes, vernachlässigt sind Wellenleitungseffekte). Intern scheint also eine 100%-ige Quantenefffizienz vorzuliegen, allerdings nur für kleine Stromdichten. Für dieses Bauelement ist die Auswahl des geeigneten Blockschichtmaterials entscheidend. Aufgrund dieser Komplexität wird es schwer sein, ein ebenso passendes Blockschicht-Material für andere Emittersysteme als Ir(ppy)₃ und andere Wirtsmaterialien als TCTA (tris(N-carbazolyl)triphenylamine, HOMO=-5,9eV, LUMO=-2,7eV) zu finden. Das verwendete Blockschichtmaterial (ein 'Starburst'-artiges Perfluorinated-Phenylen) kombiniert eine extrem niedrige HOMO-Lage mit einer extrem großen Bandlücke (über 4eV). Diese große Bandlücke hat auch den Nachteil, dass Elektronen nicht mehr so gut von der Elektronentransportschicht (LUMO ca. -3eV) in die Blockschicht (LUMO - 2.6eV, Barriere 0.4eV) injiziert werden können. Eine schrittweise Injektion von Elektronen in die lichtemittierende Schicht (5) wäre besser für eine niedrige Betriebsspannung der OLED. Das ist für die Löcherinjektion von ITO in das Löchertransportmaterial gezeigt worden (z. B. in MTDATA, ein Starburst-Ableger, HOMO=-5,1eV, LUMO=-1,9eV via Injektionsschicht, z. B. einem Phthalocyanin ZnPc, HOMO=-5,0eV, LUMO=-3,4eV, e.g. D. Ammermann et al. Jpn. J. Appl. Phys. Pt. 1, 34 (1995) 1293). Allerdings wird für eine schrittweise Elektroneninjektion von der Elektronentransportschicht (6) in die Emitterschicht (5) über die Blockschicht (6a) die Grenzfläche 6a/5 bedeutsamer, weil dann dort eine erhöhte Dichte an Elektronen und Löchern zu verzeichnen ist.

Ein Ansatz, um das Problem der Triplett-Emitter bei hohen Stromdichten zu umgehen, ist die Verwendung von "sensitized fluorescence" mit einem phosphorescenten Sinsibilisator (M.A. Baldo et al. Nature 403 (2000), 750; B.W. D'Andrade et al. Appl.Phys.Lett. 79 (2001) 1045, US 6,310,360 B1). Hierbei kommt die Lichtemission von der Fluoreszenz der Singulett-Exzitonen eines geeigneten Singulett Emitter Dotanden. Allerdings werden die Triplett Zustände auf dem Wirtsmaterial über einen zusätzlichen phosphorescenten Sensibilisator-Dotanden (dort Mischung von Triplett und Singulett Zuständen) auf den Singulett EmitterDotanden übertragen. Im Prinzip ist mit diesem Ansatz auch eine 100%-ige interne QuantenEffizienz möglich. Man kann dann die Vorteile der Singulett Emission bei höheren Stromdichten nutzen. Die Umsetzung dieses Ansatzes hat noch nicht zu herausragenden Resultaten geführt, wahrscheinlich wegen dem komplizierten Zusammenspiel der drei beteiligten Moleküle.

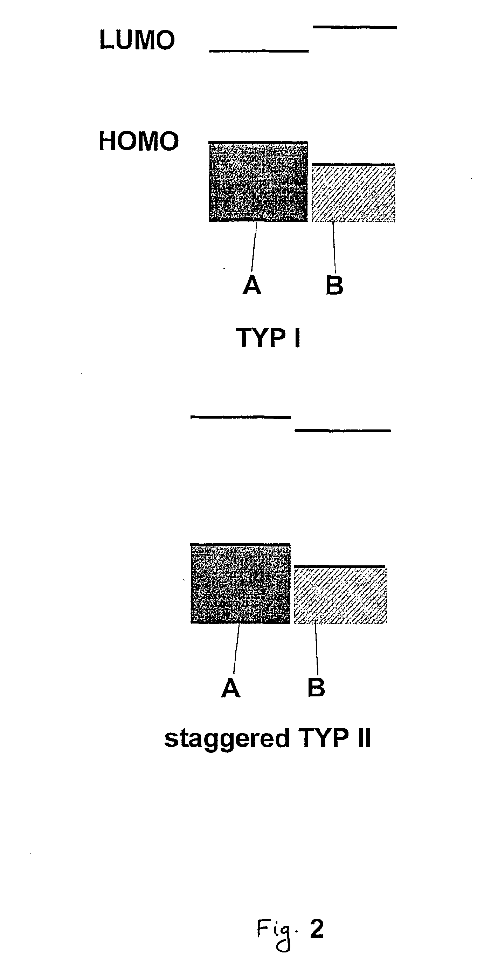

Ein weiterer Ansatz zur Erhöhung der Effizienz von Triplett-OLEDs ist bekannt von Hu et al. (W. Hu et al. Appl. Phys. Lett. 77 (2000) 4271). Er verwendet für eine rot emittierende OLED mit einer reinen Schicht als Emitterschicht (5, Europium-Komplex Eu(DBM)3TPPO) eine Löcherblockschicht für "Exzitonenconfinement", wie oben beschrieben. Wegen der langen Lebensdauer der Triplett-Exzitonen ist die Vernichtung dieser durch freie Löcher ein wichtiger Prozess. Deshalb haben Wu et al. eine OLED mit einer Mehrschichtstruktur der Emissionszone (5) vorgestellt. Die Emissionszone besteht aus mehreren (n mal) kleinen Einheiten aus dem Emitter selber und dem Blockschichtmaterial BCP (bathocuproine): {BCP 2.5nm /Eu(DBM)3TPPO 2.5nm}ₙ. Eine verdoppelte Effizienz konnte festgestellt werden, allerdings bei gleichzeitig erhöhter Betriebsspannung. Die Grenzflächen zwischen den beiden Halbleitern in diesem Fall ist vom Typ I ("Typ I heterojunction", siehe Fig. 2 oben). Diese Anordnung entsteht, wenn HOMO und LUMO-Niveaus der Materialien A (hier der Eu-complex, HOMO = 6,4eV, LUMO = 3,6eV) und B (hier BCP, HOMO = 6,7eV, LUMO = 3,2eV) so angeordnet sind, dass beide Ladungsträgertypen an den Grenzflächen zum Material B geblockt werden (beide Ladungsträgersorten befinden sich also bevorzugt auf Material A). In dem Multi-heterojunction Bauelement von Hu et al. ist die Löcherdichte hoch an der rechten Seite des Materials A (Löcher werden an der Grenzfläche Eu-Komplex zu BCP in Richtung der Kathode geblockt) und die Elektronendichte ist hoch an der linken Seite des Materials A. Daher ist der Überlapp von Löcher- und Elektronendichte nicht optimal, da beide um die Dikke der Schicht A getrennt sind. Das Argument von Hu et al. ist, dass die BCP Zwischenschichten die Löcherdichte in der Emissionsschicht minimiert. Dies ist allerdings nicht wünschenswert, da dies die Betriebsspannung der OLED erhöht. Ausserdem benötigt man für Triplett-OLEDs den Ansatz der Emitter-Dotierung ("aggregate quenching"), um hohe Effizienzen zu erreichen. Für diese ist die Multiheterojunction vom Typ I nicht mehr leicht realisierbar, da dies den Einsatz eines Blockschichtmaterials mit einer extrem hohen Bandlücke vorraussetzen würde.

In einer typischen OLED, wie in Fig. 1 dargestellt, hat die Löcherblockschicht (6a) die Funktion Löcher effizient am Verlassen der Emitterzone (5) zu behindern. Für Triplett-Emitter OLEDs besteht die Emissionszone typischerweise aus einem Wirtsmaterial mit hoher Bandlücke (wie CBP - dicarbazole-biphenyl einem bipolaren Transport Material, HOMO=-6,3eV, LUMO=-3,0eV; BCP, OXD7 - bis(butylphenyl)oxadiazole, HOMO=-6,4eV, LUMO=-2,9eV, TAZ - phenyl(naphtyl)phenyl-triazole = typische Elektronen Transporter, TCTA - tri(carbazolyl)triphenylamine einem Löchertransportmaterial). Die Bandlücken sind zwischen 3.2 und 3.5eV (diese Materialien würden unter Photoanregung blaues Licht emittieren). Diese Wirtsmaterialien werden gemischt mit Triplett-Emitter-Dotanden mit geringerer Bandlücke (ca. 2.4eV für grüne Emission, z. B. Ir(ppy)₃). Diese große Differenz zwischen den Bandlükken der Materialien hängt mit der Natur der Triplett-Exzitonen zusammen: die Exzitonen-Bindungsenergie für Triplett-Exzitonen auf organischen Materialien ist hoch. Daher hat ein Triplett-Exziton auf dem Wirtsmolekül eine niedrigere Energie als der Bandlücke entspricht. Damit noch ein effizienter Energieübertrag des Triplett-Exzitons von dem Wirt zum Dotanden stattfinden kann, muss dieser auch eine niedrigere Bandlücke aufweisen. Daher ist das typische Wirtsmaterial für grüne Singulett-Emitter-Dotanden, Alq₃, auch nicht mehr als Wirt für Triplett-Emitter-Dotanden geeignet. Wegen der hohen Bandlücke der Emissionszonen-Wirtsmoleküle müssen für die Blockschichten auch Materialien mit hoher Bandlücke eingesetzt werden. Ein Beispiel für ein Löcher blockendes Material (von Schicht 5 zu 6a) ist BCP oder BPhen (Bphen - bathophenanthroline, Bandlücke ca. 3.5eV, HOMO=-6,4eV, LUMO=-3,0eV). Die Bandlücke von BPhen ist nur wenig größer als die eines typischen Wirtsmaterials (z. B. TCTA: 3.4eV zu 3.2eV), es muss aber effizient Löcher blocken können, daher muss sein HOMO tief liegen. Bei dieser, für Triplett emittierende OLEDs typischen Anordnung, bildet die Grenzfläche zwischen den Materialien A und B (A= emitting layer material in 5, B= blocking layer material in 6a) eine sog. "Staggered Typ II heterojunction" (siehe Fig. 2, unten Seite). Die wesentliche Eigenschaft dieser Grenzfläche ist, dass beide Ladungsträgersorten an derselben Grenzfläche (nur auf unterschiedlichen Seiten) geblockt werden, also Löcher auf ihrem Weg von der Anode zur Kathode und Elektronen auf dem Weg von der Kathode zur Anode. Weil die erhöhte Dichte an Ladungsträgern beider Sorte nur durch eine Monolage Moleküle getrennt ist, ist Grenzflächenrekombination möglich. Diese Rekombination ist nur dann effizient hinsichtlich Lichterzeugung, falls diese Grenzflächen-Exzitonen in Exzitonen auf A und später auf dem Triplett Dotand in A (z. B. Ir(ppy)₃ in TCTA) transferiert werden können. Hier muss beachtet werden, dass ein Elektronenübertrag von B zu A (welcher zu Triplett Emission von A aus führt) in den meisten Fällen energetisch bevorzugt ist (auch wenn eine hohe LUMO-Barriere vorhanden ist), da das Elektron auf ein bereits positiv geladenes Molekül in A übergeht. Das LUMO Niveau in A muss nicht erreicht werden, da der energetisch stabilisierte Triplett-Zustand auf A direkt erreicht werden kann. Mit den gleichen Argumenten ist natürlich auch eine Bildung eines Exzitons auf B möglich. B ist allerdings das Blockschichtmaterial und daher nicht in der Lage, von seinem Triplett-Zustand strahlend zu rekombinieren. Dies verringert die Effizienz der OLED. Wegen der hohen Bindungsenergie des Triplett-Exzitons (bis 1.5eV) ist es also nicht ohne weiteres möglich, in einer OLED eine "staggered Typ II heterojunction" zu bilden, welche in der Lage ist, Triplett-Exzitonen nur auf dem Material (im bisherigen Beispiel A) zu erzeugen, wo effiziente Lichterzeugung von Triplettzuständen aus möglich ist.

### Zusammenfassung der Erfindung

Die Aufgabe der vorliegenden Erfindung ist es, ein lichtemittierendes Bauelement vorzuschlagen, bei dem alle erzeugten Triplett-Exzitonen zur Lichtaussendung in der Lage sind, bzw. vorher alle Ladungsträger im Bauelement zu Triplett-Exzitonen rekombinieren.

Erfindungsgemäß wird die Aufgabe durch die in den Ansprüchen 1 und 2 genannten Merkmale gelöst. Vorteilhafte Ausgestaltungen sind Gegenstand von Unteransprüchen.

Gemäß der Erfindung findet die Generation von Triplett-Exzitonen an mindestens einer internen Grenzfläche vom Typ "staggered Typ II heterojunction" zwischen zwei Materialien A (Löchertransportmaterial oder bipolares Transportmaterial) und B (Elektronentransportmaterial oder bipolares Transportmaterial) statt. Die energetische Anordnung zwischen A und B ist derart, dass ein Grenzflächen Ladungsträgerpaar mit Gesamtspin 1 (Triplett) bestehend aus einem Loch auf A und einem Elektron auf einem direkt benachbarten Molekül vom Typ B eine Energie besitzt die hoch genug ist, dass es effizient in Triplett-Exzitonen entweder auf A oder/und auf B umgewandelt werden kann. In Folge der Bauelementstruktur können alle auf A oder/und B generierten Triplett-Exzitonen effizient in sichtbares Licht transformiert werden.

Für die Emissionszone (5) sind Multiheterojunctions vom Typ II ("staggered Typ II") vorgesehen. Die Struktur der Emissionszone (5) entspricht folgender Anordnung: Material A - Material B - Material A - Material B.... ([AB]ₙ), wobei die folgenden Ausführungen und Eigenschaften möglich sind:
- Das Material A ist ein Löchertransportmaterial (und Wirt für Triplett Emitter Dotanden). Material B ist ein Elektronentransportmaterial (und Wirt für Triplett Emitter Dotanden).
- Material A kann ein bipolares Transportmaterial sein (und Wirt für Triplett Emitter Dotanden) und Material B ist ein Elektronentransportmaterial (und Wirt für Triplett Emitter Dotanden).
- Material A kann ein Löchertransportmaterial sein (und Wirt für Triplett Emitter Dotanden) und Material B ist ein bipolares Transportmaterial (und Wirt für Triplett Emitter Dotanden).

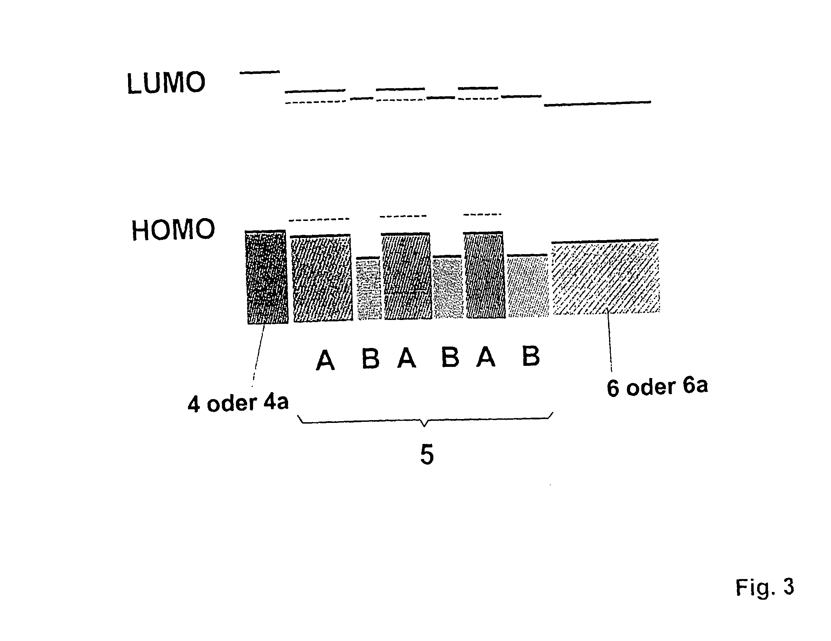

Es ist auch im Sinne der Erfindung wenn nur ein Material A oder B mit einem Triplett-Emitter Dotanden dotiert ist. Die energetische Anordnung der HOMO und LUMO Niveaus zwischen A und B muß vom Typ: "staggered Typ II heterojunction" (Fig. 2 unten Seite, Fig. 3) sein. Löcher werden also auf ihrem Weg von der Anode zur Kathode und Elektronen auf ihrem Weg von der Kathode zur Anode an jeder Grenzfläche AB aufgehalten. Die Block-Effizienz (hauptsächlich bestimmt durch die Barrierenhöhe) kann unterschiedlich für Elektronen und Löcher sein. In einem Spezialfall der vorliegenden Erfindung wird eine Sorte von Ladungsträgern nicht geblockt. Die Grenzfläche soll in diesem Fall auch als vom Typ "staggered Typ II heterojunction" angesehen werden. Die Nummer n der Grenzflächen in der Emissionszone kann 1 oder größer als 1 sein.(z. B. n=3 in Fig. 3). Wenn n=1 ist, müssen beide Materialien A und B mit einem Triplett-Emitter-Dotanden dotiert sein, damit der Aufbau im Sinne der vorliegenden Erfindung ist. Die Schichtdicken der Schichten ABABAB... müssen nicht gleich sein, vielmehr sollten sie so gewählt werden, dass eine gleichmäßige Verteilung der Ladungsträger in der Emissionszone möglich ist und die Dichte der Ladungsträger an jeder internen Grenzfläche hoch ist. Diese Nichtgleichverteilung ist besonders dann wichtig, wenn eines der Materialien A und B ein stärkerer Blocker für eine der beiden Ladungsträgersorten ist (z. B. Löcher bei der Energieniveauanordnung dargestellt in Fig. 3). Dann sollte die entsprechende Schichtdicke (im Beispiel von Material B) dünn genug sein, dass genug Ladungsträger hindurch tunneln können.

Im Falle, dass nur eine der beteiligten Schichten mit einem Triplett-Emitter-Dotanden dotiert ist (wie in Fig. 3, nur das Material A), dient die andere Schicht dazu, die Dichte der Elektronen und Löcher an den Heterojunction-Grenzflächen hoch zu halten. Das bedeutet, dass dieses Material effizient Löcher blocken muss falls es ein Elektronentransportmaterial ist, bzw. effizient Elektronen blocken muss, falls es ein Löchertransportmaterial ist. Das heisst auch, dass das undotierte Material eine höher Bandlücke aufweisen muss als das mit dem Triplett Emitter dotierte Material. Darüber hinaus muss die Energie der Triplett-Exzitonen im undotierten Material größer oder gleich der Energie der Triplett-Exzitonen in dem dotierten Material sein.

Dann ist gewährleistet, dass in dem Falle, dass ein Exziton auf dem undotierten Material (z. B. B) gebildet wurde, dieses zur nächsten Grenzfläche AB diffundieren kann und dort seine Energie an ein Triplett-Exziton auf dem dotierten Material (hier dann A) abgeben kann, bzw. ein effizienter direkter Transfer der Triplett-Exzitonen Energie auf den Triplett-Emitter-Dotanden (hier in A) möglich ist. Wegen der langen Lebensdauer der Triplett-Exzitonen auf B wird dieser Energieübertrag mit nahezu 100% Wahrscheinlichkeit stattfinden.

Im Falle, dass die Exzitonendichte an den internen Grenzflächen AB so hoch ist, dass der Effekt der "Grenzflächen-Exzitonen-Sättigung" dominant wird, erlaubt die hier vorliegende Struktur ebenso, dass Ladungsträger, welche die erste Grenzflächenzone AB verlassen haben, bei der nächsten Grenzfläche AB zu Triplett-Exzitonen rekombinieren können.

Der Aufbau der Emissionszone (5) aus mehreren Grenzflächen vom Typ "staggered Typ II heterojunction" erlaubt es parallel:
- dass alle Löcher und Elektronen rekombinieren können ohne den gegenüberliegenden Kontakt zu erreichen,
- das alle Löcher und Elektronen nahe einer aktiven Grenzfläche in der Emissionzone rekombinieren,
- dass alle Exzitonen die Emissionszone nicht verlassen können
- und dass alle Exzitonen in Bereichen der Emissionszone erzeugt werden, wo diese in der Lage sind, ihre Energie auf die in der gesamten Emissionzone oder Teilen der Emissionszone befindlichen Triplett-Emitter-Dotanden zu übertragen.

Die vorliegende Erfindung ermöglicht, alle genannten Probleme herkömmlicher Triplett-OLEDs zu vermeiden und die höchste mögliche Effizienz einer solchen OLED zu erzielen, ohne weitere Einschränkungen bei der Auswahl der Materialien, welche man benötigt, um weitere Eigenschaften (wie niedrige Betriebsspannung) zu optimieren.

### Ausführungsbeispiele der Erfindung

Die Erfindung wird im folgenden anhand von Ausführungsbeispielen unter Bezugnahme auf Figuren der Zeichnung näher erläutert. Hierbei zeigen:
- Fig. 1: ein schematisches Energiediagramm einer eingangs beschriebenen bekannten OLED Struktur, ohne angelegte Spannung, Bandverbiegungs- oder Grenzflächeneffekteinflüsse auf die Energieniveaus;
- Fig. 2: oben: ein schematisches Energiediagramm zwischen Material A und B mit einer Energieniveau-Anordnung entsprechend einer "Typ I heterojunction"; unten das Gleiche für eine "staggered Typ II heterojunction" Anordnung der Grenzfläche zwischen A und B, in diesem Beispiel ist der Löcherblockeffekt größer dargestellt (höhere Barriere);
- Fig. 3: ein schematisches Energiediagramm einer Multi-Heterojunction-Struktur vom Typ "staggered Typ II heterojunction" mit n=3 (ABABAB), hier ist nur Material A mit einem Triplett-Emitter-Dotanden dotiert, zur Vollständigkeit sind die Energielagen der umgebenden Schichten ebenso dargestellt (4, bzw. 4a; 6 bzw. 6a);
- Fig. 4: eine schematische Situation in einer Anordnung wie sie im BEISPIEL 2 (unten) beschrieben, ABABAB-Struktur;
- Fig. 5: eine schematische Situation in einer Anordnung wie sie im BEISPIEL 3 (unten) beschrieben, AB Struktur (A und B sind dotiert); und
- Fig. 6: Stromeffizienz (current efficiency) vs. Stromdichte-Kennlinien für eine STANDARD OLED, eine OLED wie in BEISPIEL 4 (n=2) und einer OLED wie in BEISPIEL 3 (n=1 mit dotierter Löchertransportschicht und dotierter Elektronentransportschicht).

Eine bevorzugte Ausführung der vorliegenden Erfindung wird jetzt vorgestellt. Es zeigt den allgemeinen Fall der Multi-Heterojunction innerhalb der Emissionsszone (5).

Die OLED mit Emission von den Triplett-Exzitonen besteht aus folgenden Schichten:

### BEISPIEL 1

- 1.: Substrat,
- 2.: Grundelektrode, z. B. Löcherinjektion (Anode),
- 3.: Löcherinjektionsschicht,
- 4.: Löchertransportschicht (HTL),
- 4a.: evtl. Blockschicht, löcherseitig, Lichtemissionszone = Multi-Heterojunction (n=3)
- 5A1d.: Löchertransportmaterial (oder bipolares Transportmaterial), dotiert mit Emitter-Dotand,
- 5B1d. oder 5B1u.: Elektronentransportschicht (oder bipolare Transportschicht), evtl. dotiert mit Emitter-Dotand,
- 5A2d.: Löchertransportmaterial (oder bipolares Transportmaterial), dotiert mit Emitter-Dotand,
- 5B2d oder 5B2u.: Elektronentransportschicht (oder bipolare Transportschicht), evtl. dotiert mit Emitter-Dotand,
- 5A3d.: Löchertransportmaterial (oder bipolares Transportmaterial), dotiert mit Emitter-Dotand,
- 5B3d oder 5B3u.: Elektronentransportschicht (oder bipolare Transportschicht), evtl. dotiert mit Emitter-Dotand,
- 6.: Elektronentransportschicht (ETL),
- 7.: Elektroneninjektionsschicht,
- 8.: Deckelektrode (Kathode),
- 9.: Kapselung, wobei die Grenzfläche ABAB... vom Typ "staggered Typ II heterojunction" sind.

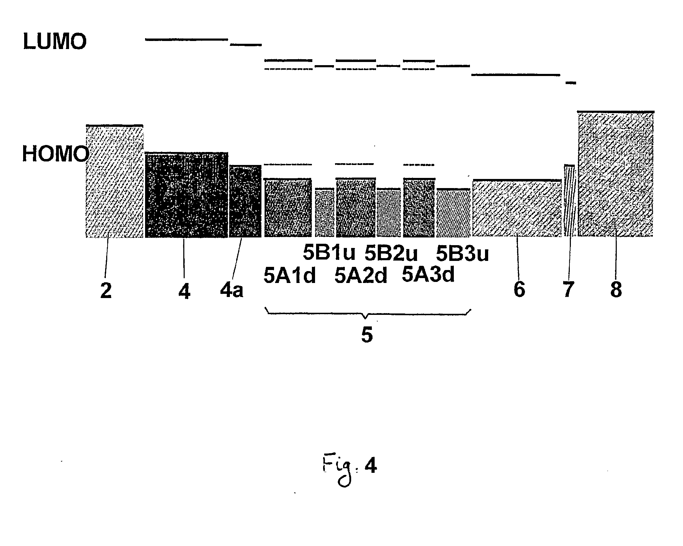

Eine typische Realisierung der soeben beschriebenen Ausführung ist die folgende Materialsequenz (vgl. Fig. 4). Diese Materialien sind Beispiele, welche eine Schichtsequenz in Übereinstimmung mit der vorliegenden Erfindung demonstrieren sollen:

### BEISPIEL 2

- 1.: Glassubstrat,
- 2.: ITO-Anode,
- 4.: Starburst (MTDATA) dotiert mit F4-TCNQ 100nm (Leitfähigkeitserhöhung),
- 4a.: TPD (triphenyldiamine) 5nm, HOMO=-5,4eV, LUMO=-2,4eV, Lichtemissionszone = Multi-Heterojunction (n=3)
- 5A1d.: TCTA dotiert mit Ir(ppy)₃ als Triplett Emitter 10nm,
- 5B1u.: Bphen 5nm
- 5A2d.: TCTA:Ir(ppy)₃ 15nm,
- 5B2u.: BPhen 5nm
- 5A3d.: TCTA:Ir(ppy)₃ 2nm,
- 5B3u.: Bphen 10nm
- 6.: Alq₃ 40nm,
- 7.: LiF (lithium-fluoride) 1nm,
- 8.: Aluminium (cathode).

In diesem Fall ist die Grenzfläche AB so ausgeführt, dass Löcher effizienter an der Grenzfläche AB geblockt werden. Das ist notwendig, da nur Material A mit dem Emitter Dotanden dotiert ist, und daher die höhere Ladungsträgerdichte im Material A sein sollte. Noch wichtiger aber ist die Tatsache, dass die Triplett-Exzitonen in B eine größere Energie als die in A besitzen. Daher können die auf B erzeugten Exzitonen später in Exzitonen auf A (oder dem Emitter Dotand in A) umgewandelt werden.

Aus der Energieniveauanordnung in Fig. 4 sieht man, dass
- Exzitonen, welche in der inneren Triplett-Emitter dotierten Schicht TCTA erzeugt werden (5A2, dieselben Argumente gelten auch für die Schichten 5A1 und 5A3), können diese nicht verlassen, weil der Triplett Zustand auf BPhen einen höhere Energie aufweist.
- Exzitonen, welche in den Schichten 5B1 und 5B2 erzeugt werden, können in beide Richtungen zu einer Grenzfläche mit TCTA:Ir(ppy)₃ diffundieren, wo sie in Triplett-Exzitonen auf TCTA oder auf Ir(ppy)₃ umgewandelt werden können (kleinere Energie dieser Triplett-Exzitonen). Diese rekombinieren unter Lichtaussendung.
- Löcher, welche durch die Emissionszone gelangen, können später an der Grenzfläche zwischen 5A3 und 5B3 zu Triplett-Exzitonen rekombinieren, hauptsächlich zu solchen auf 5A3 (hier TCTA:Ir(ppy)₃).
- Elektronen, welche durch die Emissionzone gelangen, können später an der Grenzfläche zwischen 5A1 und 4a mit Löchern an dieser Grenzfläche rekombinieren (diese werden an der Grenzfläche 4a zu 5A1 schwach geblockt). Dort können sie Exzitonen auf TCTA oder Ir(ppy)₃ bilden (in 5A1).

Die Dicken der verschiedenen Schichten sind so gewählt, dass eine gute Balance zwischen Löchern und Elektronen innerhalb der Emissionszone erreicht wird (Balance zwischen Blockeffekten und Ladungsträgertransport). Deshalb ist die Dicke der letzten TCTA:Ir(ppy)₃ Schicht (5A3) geringer als die der Schichten 5A1 und 5A2. Das erlaubt eine gute Elektroneninjektion in die anderen emitterdotierten Schichten (5A1 und 5A2), weil TCTA eine relativ geringe Barriere für Elektroneninjektion, aber eine niedrige Elektronenbeweglichkeit aufweist. Die Dicke der Schicht 5A3 ist aber groß genug, damit die restlichen Löcher, welche diese Schicht erreichen, mit den dort vorhandenen Elektronen rekombinieren können. Alle injizierten Löcher und Elektronen werden innerhalb der Emissionszone rekombinieren und später strahlend zerfallen, weil alle gebildeten Exzitonen in der Lage sind einen Teil der Emissionszone zu erreichen, in dem sie über Triplett-Emitter-Dotanden zerfallen können. Die OLED würde ebenso gut funktionieren, wenn das Blockschicht- und Elektronentransportmaterial (BPhen) innerhalb der Emissionzone ebenso mit dem gleichen oder einem anderen Triplett-Emitter-Dotanden dotiert wäre.

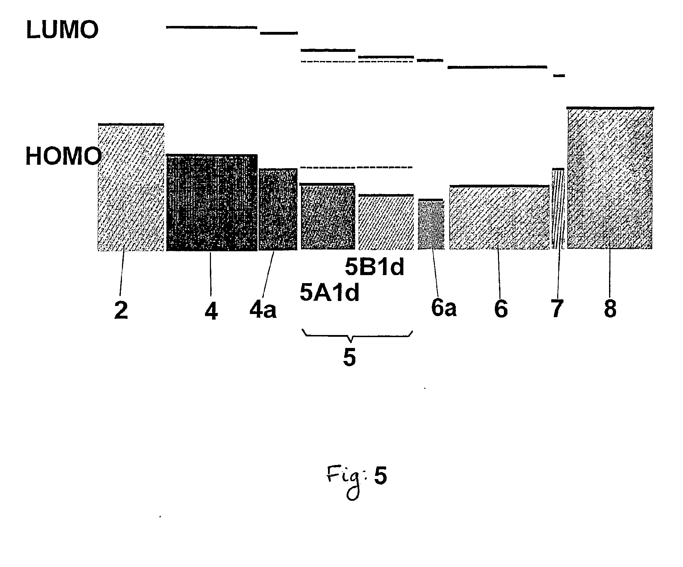

Die Anzahl der Heterojunctions, welche n=3 in den beiden vorigen Beispielen war, kann höher oder niedriger sein. Im Fall von n=1, müssen beide Materialien A und B der Heterojunction mit einem Triplett-Emitter-Dotanden dotiert sein, um eine Struktur in Übereinstimmung mit der vorliegenden Erfindung zu erhalten. Ein bevorzugtes Ausführungsbeispiel mit Beispiel-Materialien ist (vgl. Fig. 5):

### BEISPIEL 3

- 1.: Substrat,
- 2.: Grundelektrode, z. B. ITO-Anode,
- 3.: Löcherinjektionsschicht, z. B. ein Phthalocyanin,
- 4.: Löchertransportschicht, z. B. MTDATA:F4-TCNQ,
- 4a.: Blockschicht auf der Löcherseite, z. B. TPD Lichtemissionszone = Multi-Heterojunction (n=1)
- 5A1d.: Löchertransportschicht, dotiert mit Emitter Dotanden, z. B. TCTA:Ir(ppy)₃,
- 5B1d.: Elektronentransportschicht und Löcherblockschicht, dotiert mit Emitter Dotanden, z. B. BPhen:Ir(ppy)₃,
- 6a.: Blockschicht auf Elektronenseite, z. B. BCP,
- 6.: Elektronentransportschicht, z. B. Alq₃,
- 7.: Elektroneninjektionsschicht, z. B. LiF,
- 8.: Deckelektrode (Kathode), z. B. Aluminium.

Die Exzitonenbildung findet in dieser OLED Struktur wiederum nahe der Grenzfläche 5A1 und 5B1 statt (weil diese ein "stagered Typ II heterojunction" bildet). Grenzflächen-Exzitonen können ihre Energie entweder auf ein Triplett-Exziton in der Schicht 5A1 oder 5B1 übertragen. Beide Schichten sind mit einem Triplett-Emitter-Dotanden dotiert. Dort können Sie diffundieren, werden aber an den Grenzflächen zu 4a und 6a aufgehalten und zerfallen daher strahlend in den dotierten Schichten. Die Verwendung von Löchertransportmaterialien und Elektronentransportmaterialien, beide dotiert mit einem Triplett-Emitter, erlaubt es, dass alle Exzitonen strahlend rekombinieren können.

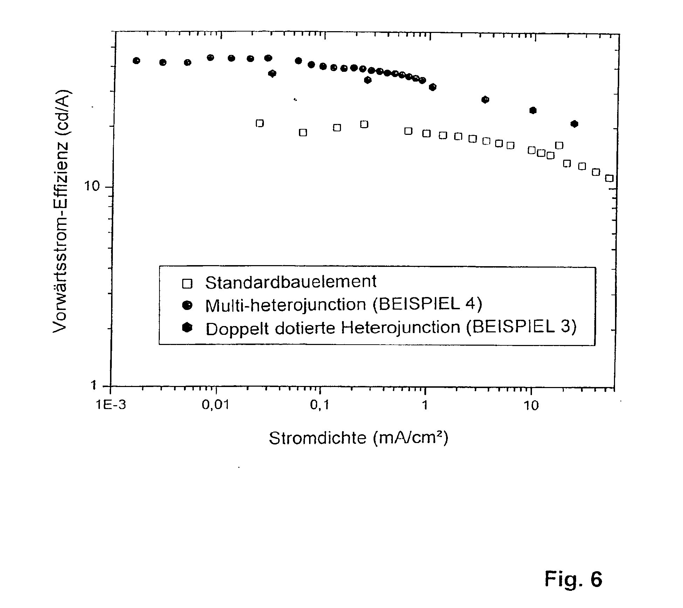

In Fig. 6 ist die Stromeffizienz-Stromdichte Kennlinie einer Probe in Übereinstimung mit Ausführungsbeispiel BEISPIEL 3 gezeigt. Die exakte OLED Struktur ist: ITO / 100nm p-dotiertes MTDATA (4) / 10nm Ir(ppy)₃ dotiertes TCTA (5A1d) / 10nm Ir(ppy)₃ dotiertes Bphen (5B1d) / 40nm Bphen (6) / 1m LiF (7) / Al (8). In dieser Ausführung vereint die Schicht (4) Löchertransport- und Blockschichteigenschaften.

Im Folgenden wird ein weiteres Ausführungsbeispiel mit Beispielmaterialien präsentiert und deren optoelektronische Eigenschaften werden mit einer Standard-Probe (ohne Heterojunction in der Emissionszone) verglichen:

### BEISPIEL 4

- 1.: Substrat,
- 2.: ITO-Anode,
- 4.: MTDATA:F4-TCNQ 100nm, Lichtemissionszone = Multi-Heterojunction (n=2)
- 5A1d.: TCTA:Ir(ppy)₃ 20nm,
- 5B1u.: BPhen 10nm,
- 5A2d.: TCTA:Ir(ppy)₃ 1.5nm,
- 5B2u.: BPhen 20nm,
- 6.: Alq₃ 30nm
- 7.: LiF 1nm
- 8.: Aluminium.

In dieser Struktur wurden die Blockschichten weggelassen, weil (i) MTDATA bereits effizient Elektronen blockt, und (ii) die letzte Schicht der Multi-Hetreojunction (5B2) ebenso bereits als Blockschicht für Löcher fungiert.
Die Standard-Struktur besteht aus:

### STANDARD STRUKTUR

- 2:: ITO
- 4:: MTDATA:F4TCNQ 100 nm
- 5:: TCTA: Irppy 20 nm
- 6a:: BPhen 20 nm
- 6:: Alq₃ 30 nm
- 7:: LiF 1nm
- 8:: Al.

In Fig. 6 wird die Effizienz dieser beiden OLEDs verglichen (in Abhängigkeit von der Stromdichte). Die Effizienz ohne Multi-Heterojunction ist maximal 20cd/A, die mit Multi-Heterojunction (n=2) über 40cd/A. Die OLED Effizienz konnte um den Faktor 2 erhöht werden ohne andere Materialien in der OLED zu verwenden. Fig. 6 zeigt außerdem die Effizienz-Kurve der OLED aus BEISPIEL 3. Auch diese zeigt eine Verdopplung der Effizienz.

Die Erhöhung der Stromeffizienz kann nicht auf Mikrokavitätseffekte zurückgeführt werden, weil die absoluten Schichtdicken der Proben ungefähr gleich sind und sich die Brechungsindizes der organischen Schichten nur marginal unterscheiden. Also kann keine Leuchtdichteerhöhung in Vorwärtsrichtung erwartet werden.

Heterojunctions in der Emissionszone von OLEDs sind bekannt von OLEDs mit Emission von Singulett-Exzitonenzuständen. Im Unterschied zur vorliegenden Erfindung werden dort meist undotierte Schichten in sog. Multiplen Quantentopfstrukturen "multiple quantum well structures" verwendet (Y. Ohmori et al. Appl. Phys. Lett. 62 (1993), 3250; Y. Ohmori et al. Appl. Phys. Lett. 63 (1993), 1871). Diese Quantentopfstrukturen (manchmal auch Suppergitter "superlattices" oder Multischichtstruktur genannt) sind so ausgelegt, dass das Emissionsspektrum der OLED beeinflusst werden kann. Es wurde aber festgestellt, dass solche Strukturen (z. B. Alq₃ im Wechsel mit TPD, diese Grenzfläche ist auch eine vom Typ II) zu keiner wesentlichen Erhöhung der Effizienz der OLED führt. Mori et al. (T. Mori et al. J. Phys. D - Appl. Phys. 32 (1999), 1198) haben den Effekt einer "stacked structure" auf OLEDs mit Singulett-Emitter-Dotanden in der Emissionszone untersucht und sogar eine Verringerung der Effizienz der OLED festgestellt. Daher ist anzumerken, dass die Mehrfachschicht-Emissionszone vom Typ II im Fall der Singulett-Emission anders arbeitet als im Falle der oben beschriebenen Triplett Emission. Dies hängt, wie ausgeführt, mit der längeren Triplett-Exzitonen Lebensdauer und der erhöhten Exzitonen Bindungsenergie zusammen. Der Grund dafür ist die Möglichkeit für Singulett-Exzitonen relativ leicht eine Grenzfläche vom Typ II aufzubauen, an der Exzitonen nur auf einer Seite der Grenzfläche gebildet werden, nämlich bevorzugt der mit der höheren Ausbeute an strahlender Rekombination von den Singulett-Exzitonen-Zuständen. Wegen der höheren Bindungsenergie der Triplett-Exzitonen werden allerdings diese Triplett-Exzitonen auf beiden Materialien der Grenzfläche gebildet. Der Vorteil von Bauelementen auf der Basis der in diesem Patent vorgeschlagenen Struktur ist, dass sie effizient Löcher und Elektronen "einsammeln" und in Licht umwandeln kann.

In einer Arbeit von Huang et al. (J.S. Huang Jpn. J. Appl. Phys. 40 (2001) 6630) wurde eine Multiquantentopfstruktur vorgestellt, welche mit Spiro-TAD (eine stabiler Version des Materials TPD) und Alq₃ (also Typ II Grenzflächen) eine Emissionszone (5) in einem StandardAufbau aufbaut. Auch dort konnte keine nennenswerte Erhöhung der Effizienz festgestellt werden (von 4 zu 4.5cd/A bei 4.5V Betriebsspannung). Andererseits fand Huang et al. (J.S. Huang et al. Appl. Phys. Lett. 73 (1998) 3348) einen nenneswerten Anstieg der Effizienz für eine Multischichtstruktur mit Alq₃ und Rubrene (ein oranger Singulett-Emitter-Farbstoff) dotiert in Alq₃ in der Emissionszone (5). Diese Struktur bildet Typ I Heterojunctions, wo nur die Exzitonen in der Rubrene dotierten Schichten "gefangen" werden und ist somit nicht in Übereinstimmung mit diesem Patent. Ein weiterer Ansatz in Singulett-Emitter OLEDs ist der von Sakamoto et al. (G. Sakamoto et al. Appl. Phys. Lett. 75 (1999) 766). Er stellte eine OLED Sruktur mit der Schichtfolge: Anode / Löcherinjektionsschicht / Löchertransportschicht dotiert mit Rubrene / Elektronentransportschicht und Emitterschicht (Alq₃) dotiert mit Rubrene / Kathode vor. Die Effizienz dieses Bauelementes konnte nur wenig erhöht werden, verglichen mit dem Bauelement bei dem nur die Emissionsschicht mit Rubrene dotiert war. Der hauptsächliche Effekt war eine Erhöhung der Lebensdauer der OLED. Die Ursache der höheren Stabilität liegt in der Verringerung der Dichte an freien Löchern in der Emissionschicht Alq₃, was zu einer verringerten irreversiblen Oxidation von Alq₃ führt. Der geringe Anstieg der Effizienz in der doppelt dotierten OLED kann auf eine verbesserte Balance von Löchern und Elektronen in der Emissionschicht zurückgeführt werden.

Die oben ausgeführten Beispiele beschreiben das hier vorgestellte Konzept. Der Spezialist auf dem Gebiet kann viele weitere Ausführungsbeispiele in Übereinstimmung mit der vorliegenden Erfindung vorschlagen, welche hier nicht alle im Einzelnen diskutiert werden können. Zum Beispiel ist es klar, dass die Bauelemente-Struktur ABAB... auch vom Typ ABCD... sein kann, wenn Material C ähnliche Eigenschaften wie Material A hat (Löchertransport oder bipolarer Transport) und Material D ähnliche Eigenschaften wie Material B aufweist (Elektronentransport oder bipolarer Transport) und die Grenzflächen vom Typ II sind.

### Bezugszeichenliste

- 1: Substrat
- 2: Anode / Kathode
- 3: Löcherinjektionsschicht (evtl. dotiert um die Leitfähigkeit zu erhöhen)
- 4: Löchertransportschicht (evtl. dotiert um die Leitfähigkeit zu erhöhen)
- 4a: Blockschict auf der Löcherseite
- 5: Licht emittierende Schicht, kann aus verschiedenen Schichten bestehen: 5A1d, 5A2d, 5A3d Multi-Heterojunction Material vom Typ A (Löcher-transport), dotiert mit Emitter Dotanden
- 5B1d, 5B2d, 5B3d: Multi-Heterojunction Material vom Typ B (Elektronentransport und Löcherblocker), dotiert mit Emitter Dotanden
- 5B1u, 5B2u, 5B3u: Multi-Heterojunction Material vom Typ B (Elektronentransport und Löcherblocker), nicht dotiert mit Emitter-Dotanden
- 6a: Blockschicht Elektronenseite
- 6: Elektronentransportschicht (evtl. dotiert um die Leitfähigkeit zu erhöhen)
- 7: Elektroneninjektionsschicht (evtl. dotiert um die Leitfähigkeit zu erhöhen)
- 8: Kathode
- 9: Kapselung

- A: erster Teil der Heterojunction
- B: zweiter Teil der Heterojunction

## Patentansprüche

1. Lichtemittierendes Bauelement mit organischen Schichten und Emission von Triplett-Exzitonen Zuständen (phosphoreszentes Licht) mit erhöhter Effizienz, aufweisend eine Schichtreihenfolge mit einem löcherinjizierenden Kontakt (Anode) (2), einer oder mehreren löcherinjizierenden und -transportierenden Schichten (3, 4), einem System von Schichten (5) in der Lichtemissionszone, einer oder mehreren elektroneninjizierenden und -transportierenden Schichten (6, 7) und einem elektroneninjizierenden Kontakt (Kathode) (8), **dadurch gekennzeichnet, dass** die Lichtemissionszone aus einer Reihe von Heteroübergängen (ABAB...; ABCD...) besteht, welche zwischen den Schichten (5) Grenzflächen vom Typ "staggered Typ II" bilden, bei denen ein niedrigstes unbesetztes Energieniveau (LUMO) eines Materials (A; C) energetisch höher liegt als ein niedrigstes unbesetztes Energieniveau (LUMO) eines anderen Materials (B; D) und bei denen ein höchstes besetztes Energieniveau (HOMO) des Materials (A; C) energetisch höher liegt als ein höchstes besetztes Energieniveau (HOMO) des anderen Materials (B; D), wobei in dem System gestapelter Schichten abwechselnd eine Schicht aus dem Material (A; C) mit löchertransportierenden oder bipolaren Transporteigenschaften und eine Schicht aus dem anderen Material (B; D) mit elektronentransportierenden oder bipolaren Transporteigenschaften angeordnet sind und wobei mindestens eines der Materialien mit einem Triplett-Emitter-Dotanden gemischt ist.

2. Lichtemittierendes Bauelement mit organischen Schichten und Emission von Triplett-Exzitonen Zuständen (phosphoreszentes Licht) mit erhöhter Effizienz, aufweisend eine Schichtreihenfolge mit einem löcherinjizierenden Kontakt (Anode) (2), einer oder mehreren löcherinjizierenden und -transportierenden Schichten (3, 4), einem System von Schichten (5) in der Lichtemissionszone, einer oder mehreren elektroneninjizierenden und -transportierenden Schichten (6, 7) und einem elektroneninjizierenden Kontakt (Kathode) (8), **dadurch gekennzeichnet, dass** die Lichtemissionszone aus einem Heteroübergang mit den Materialien A und B (AB) besteht, wobei die Grenzfläche vom Typ "staggered Typ II" ist, bei der ein niedrigstes unbesetztes Energieniveau (LUMO) eines Materials (A) energetisch höher liegt als ein niedrigstes unbesetztes Energieniveau (LUMO) eines anderen Materials (B) und bei der ein höchstes besetztes Energieniveau (HOMO) des Materials (A) energetisch höher liegt als ein höchstes besetztes Energieniveau (HOMO) des anderen Materials (B), wobei das Material (A) löchertransportierende oder bipolare Transporteigenschaften aufweist und das andere Material (B) elektronentransportierende oder bipolare Transporteigenschaften aufweisen und wobei beide Materialien (A, B) mit einem Triplett-Emitter-Dotanden gemischt sind.

3. Lichtemittierendes Bauelement nach Anspruch 1 oder 2, **dadurch gekennzeichnet, dass** die Materialien in der Lichtemissionszone mit dem gleichen Triplett-Emitter-Dotariden gemischt sind.

4. Lichtemittierendes Bauelement nach Anspruch 1 oder 2, **dadurch gekennzeichnet, dass** das Material (A) mit einem Triplett-Emitter-Dotanden und das Material (B) mit einem anderen Triplett-Emitter-Dotanden gemischt sind.

5. Lichtemittierendes Bauelement nach Anspruch 1, **dadurch gekennzeichnet, dass** nur das Material A (bzw. B) mit einem Triplett-Emitter-Dotanden gemischt ist, wobei die Energie des niedrigsten Triplett-Zustandes auf Material B (bzw. A) mindestens so groß ist wie die des Triplett-Zustandes auf Material A (bzw. B).

6. Lichtemittierendes Bauelement nach Anspruche 1, **dadurch gekennzeichnet, dass** Material A (bzw. Material B) mit einem Triplett-Emitter-Dotanden gemischt ist und Material B (bzw. A) mit einem Emitter-Dotanden gemischt ist, wobei die Energie des niedrigsten Triplett-Zustandes auf B (bzw. A) mindestens so groß ist wie die des Triplett-Zustandes auf Material A (bzw. B).

7. Lichtemittierendes Bauelement nach einem der Ansprüche 1, 3, 4 bis 6, **dadurch gekennzeichnet, dass** der Heteroübergang in der Lichtemissionszone zwischen 2-mal (A1B1A2B2) und 10-mal ([AB]₁₀) vorkommt.

8. Lichtemittierendes Bauelement nach einem der Ansprüche 1 bis 7, **dadurch gekennzeichnet, dass** die Grenzflächen zwischen A und B in der Lage sind, Löcher (bzw. Elektronen) an der Grenzfläche von A zu B (bzw. von B zu A) zu blocken und Elektronen (bzw. Löcher) an der Grenzfläche von B zu A (bzw. von A zu B) nur schwach zu behindern (Barriere für Ladungsträgerinjektion <0.2eV), und das Material B (bzw. A) eine größere Bandlücke als Material A (bzw. B) besitzt.

9. Lichtemittierendes Bauelement nach Anspruch 1 bis 8, **gekennzeichnet durch** eine Blockschicht (4a) zwischen einer innersten Löchertransportschicht (4) und einer ersten Lichtemissionsschicht (A1) (5), wobei eine Barriere für Elektroneninjektion von A1 in die Löchertransportschicht (4) gebildet ist.

10. Lichtemittierendes Bauelement nach Anspruch 1 bis 9, **gekennzeichnet durch** eine Blockschicht (6a) zwischen einer innersten Elektronentransportschicht (6) und einer letzten Lichtemissionsschicht (Bn), wobei eine Barriere für Löcherinjektion von der Lichtemissionsschicht (5) in die Elektronentransportschicht (6) gebildet ist.

11. Lichtemittierendes Bauelement nach einem der Ansprüche 1 bis 10, **dadurch gekennzeichnet, dass** die Schichtdicken der organischen Schichten im Bereich 0.1nm bis 50µm liegt.

12. Lichtemittierendes Bauelement nach einem der Ansprüche 1 bis 11, **dadurch gekennzeichnet, dass** die Schichten aus im Vakuum aufgedampften kleinen Molekülen bestehen oder ganz oder teilweise aus Polymeren.

13. Lichtemittierendes Bauelement nach einem der Ansprüche 1 bis 12, **dadurch gekennzeichnet, dass** die gemischten Schichten mittels Mischverdampfung im Vakuum, Aufbringen einer gemischten Schicht aus einer Lösung oder Hintereinanderaufbringen der Materialien mit anschließender Diffussion der Dotanden in die Schichten hergestellt sind.

## Claims

1. A light emitting component with organic layers and emission of triplet exciton states (phosphorescent light) with increased efficiency, having a layer sequence with a hole injecting contact (anode) (2), one or more hole injecting and transporting layers (3, 4), a system of layers (5) in the light emission zone, one or more electron injection and transport layers (6, 7) and an electron injecting contact (cathode) (8), **characterized in that** the light emitting zone comprises a series of heterojunctions (ABAB...; ABCD...) that form interfaces of the type "staggered type II" between layers (5), wherein a lowest unoccupied energy level (LUMO) of a material (A; C) lies energetically higher than a lowest unoccupied energy level (LUMO) of another material (B; D) and a highest occupied energy level (HOMO) of said material (A; C) lies energetically higher than a highest occupied energy level (HOMO) of said other material (B; D), wherein in the system of stacked layers a layer of said material (A; C) having hole transporting or bipolar transport properties and a layer of said other material (B; D) having electron transporting or bipolar transport properties are arranged alternately, and at least one of the materials is mixed with a triplet emitter dopant.

2. A light emitting component with organic layers and emission of triplet exciton states (phosphorescent light) with increased efficiency, having a layer sequence with a hole injecting contact (anode), one or more hole injecting and transporting layers, a system of layers in the light emission zone, one or more electron transport and injection layers and an electron injecting contact (cathode), **characterized in that** the light emitting zone comprises a heterojunction with the materials A and B (AB), the interface being of the type "staggered type II", wherein a lowest unoccupied energy level (LUMO) of a material (A) lies energetically higher than a lowest unoccupied energy level (LUMO) of another material (B) and a highest occupied energy level (HOMO) of said material (A) lies energetically higher than a highest occupied energy level (HOMO) of said other material (B), material (A) having hole transporting or bipolar transport properties and the other material (B) having electron transporting or bipolar transport properties, and both materials A or B being mixed with a triplet emitter dopant.

3. The light emitting component as claimed in claim 1 or 2, **characterized in that** the materials in the light emission zone are mixed with the same triplet emitter dopant.

4. The light emitting component as claimed in claims 1 or 2, **characterized in that** material (A) is mixed with a triplet emitter dopant and material (B) is mixed with another triplet emitter dopant.

5. The light emitting component as claimed in claim 1, **characterized in that** only material A (or material B) is mixed with a triplet emitter dopant, the energy of the lowest triplet state on material B (or material A) being at least as large as that of the triplet state on material A (or B).

6. The light emitting component as claimed in claim 1, **characterized in that** material A (or material B) is mixed with a triplet emitter dopant and material B (or A) is mixed with an emitter dopant, the energy of the lowest triplet state on B (or A) being at least as great as that of the triplet state on material A (or B).

7. The light emitting component as claimed in claims 1, 3, 4 to 6, **characterized in that** the heterojunction occurs in the light emission zone between two times (A1B1A2B2) and ten times ([AB]₁₀).

8. The light emitting component as claimed in one of claims 1 to 7, **characterized in that** the interfaces between A and B are able to block holes (or electrons) at the interface from A to B (or from B to A) and to only weakly impede electrons (or holes) at the interface from B to A (or from A to B) (barrier for charge carrier injection < 0.2 eV), and the material B (or A) has a larger band gap than material A (or B).

9. The light emitting component as claimed in claim 1 to 8, **characterized by** a blocking layer between an innermost hole transport layer (4) and a first light emission layer (A1) (5), there existing a barrier for electron injection from A1 into the hole transport layers.

10. The light emitting component as claimed in claim 1 to 9, **characterized by** a blocking layer (6a) between an innermost electron transport layer (6) and a last light emission layer (Bn), there existing a barrier for hole injection from the light emission layer (5) into the electron transport layer (6).

11. The light emitting component as claimed in one of claims 1 to 10, **characterized in that** the layer thicknesses of the organic layers lie in the range of 0.1 nm to 50 µm.

12. The light emitting component as claimed in one of claims 1 to 11, **characterized in that** the layers comprise small molecules that are vapor deposited in vacuo, or completely or partly comprise polymers.

13. The light emitting component as claimed in one of claims 1 to 16, **characterized in that** the mixed layers are produced by mixing vaporization in vacuo, or by application of a mixed layer from a solution or by successive application of the materials with subsequent diffusion of the dopants into the layers.

## Revendications

1. Composant électroluminescent comprenant des couches organiques et émission à partir d'excitons à l'état triplet (lumière phosphorescente) avec une efficacité accrue, présentant une suite de couches comprenant une couche contact d'injection de trous (anode) (2), une ou plusieurs couches d'injection et de transport de trous (3, 4), un système de couches (5) dans la zone d'émission de lumière, une ou plusieurs couches d'injection et de transport d'électrons (6, 7) et une couche contact d'injection d'électrons (cathode) (8), **caractérisé en ce que** la zone d'émission de lumière se compose d'une suite d'hétérojonctions (ABAB... ; ABCD...) qui forment, entre les couches (5), des interfaces du type "décalé II", dans lesquelles un plus bas niveau d'énergie inoccupé (LUMO) d'une matière (A ; C) est énergétiquement supérieur à un plus bas niveau d'énergie inoccupé (LUMO) d'une autre matière (B ; D) et dans lesquelles un plus haut niveau d'énergie occupé (HOMO) de la matière (A ; C) est énergétiquement supérieur à un plus haut niveau d'énergie occupé (HOMO) de l'autre matière (B ; D), dans lequel, dans le système de couches empilées, une couche d'une matière (A ; C) présentant des propriétés de transport de trous ou bipolaires et une couche de l'autre matière (B ; D) présentant des propriétés de transport d'électrons ou bipolaires sont disposées de manière alternée, et dans lequel au moins une des matières est mélangée à un dopant émetteur à l'état triplet.

2. Composant électroluminescent comprenant des couches organiques et émission à partir d'excitons à l'état triplet (lumière phosphorescente) avec une efficacité accrue, présentant une suite de couches comprenant une couche contact d'injection de trous (anode) (2), une ou plusieurs couches d'injection et de transport de trous (3, 4), un système de couches (5) dans la zone d'émission de lumière, une ou plusieurs couches d'injection et de transport d'électrons (6, 7) et une couche contact d'injection d'électrons (cathode) (8),
**caractérisé en ce que** la zone d'émission de lumière se compose d'une hétérojonction entre les matières A et B (AB), dans laquelle l'interface est du type "décalé II", dans laquelle un plus bas niveau d'énergie inoccupé (LUMO) d'une matière (A) est énergétiquement supérieur à un plus bas niveau d'énergie inoccupé (LUMO) d'une autre matière (B) et dans laquelle un plus haut niveau d'énergie occupé (HOMO) de la matière (A) est énergétiquement supérieur à un plus haut niveau d'énergie occupé (HOMO) de l'autre matière (B), dans lequel la matière (A) présente des propriétés de transport de trous ou bipolaires et l'autre matière (B) présente des propriétés de transport d'électrons ou bipolaires, et dans lequel les deux matières (A, B) sont mélangées à un dopant émetteur à l'état triplet.

3. Composant électroluminescent selon la revendication 1 ou 2, **caractérisé en ce que** les matières dans la zone d'émission de lumière sont mélangées au même dopant émetteur à l'état triplet.

4. Composant électroluminescent selon la revendication 1 ou 2, **caractérisé en ce que** la matière (A) est mélangée à un dopant émetteur à l'état triplet et la matière (B) est mélangée à un autre dopant émetteur à l'état triplet.

5. Composant électroluminescent selon la revendication 1, **caractérisé en ce que** seule la matière A (ou B) est mélangée à un dopant émetteur à l'état triplet, dans lequel l'énergie du plus bas état triplet sur la matière B (ou A) est au moins égale à celle de l'état triplet sur la matière A (ou B).

6. Composant électroluminescent selon la revendication 1, **caractérisé en ce que** la matière A (ou B) est mélangée à un dopant émetteur à l'état triplet et la matière B (ou A) est mélangée à un dopant émetteur, dans lequel l'énergie du plus bas état triplet sur B (ou A) est au moins égale à celle de l'état triplet sur la matière A (ou B).

7. Composant électroluminescent selon l'une quelconque des revendications 1, 3, 4 à 6,
**caractérisé en ce que** l'hétérojonction dans la zone d'émission de lumière survient entre deux fois (A1B1A2B2) et 10 fois ([AB]₁₀).

8. Composant électroluminescent selon l'une quelconque des revendications 1 à 7, **caractérisé en ce que** les interfaces entre A et B sont en mesure de bloquer les trous (ou les électrons) à l'interface de A à B (ou de B à A) et de ne bloquer que faiblement les électrons (ou les trous) à l'interface de B à A (ou de A à B) (barrière à l'injection de porteurs de charge < 0,2 eV), et **en ce que** la matière B (ou A) possède une bande interdite plus grande que la matière A (ou B).

9. Composant électroluminescent selon les revendications 1 à 8, **caractérisé par** une couche bloquante (4a) située entre une couche de transport de trous la plus interne (4) et une première couche d'émission de lumière (A1) (5), dans lequel une barrière à l'injection d'électrons à partir de A1 dans la couche de transport de trous (4) est ainsi formée.

10. Composant électroluminescent selon les revendications 1 à 9, **caractérisé par** une couche bloquante (6a) située entre une couche de transport d'électrons la plus interne (6) et une dernière couche d'émission de lumière (Bn), dans lequel une barrière à l'injection de trous à partir de la couche d'émission de lumière (5) dans la couche de transport d'électrons (6) est ainsi formée.

11. Composant électroluminescent selon l'une quelconque des revendications 1 à 10,
**caractérisé en ce que** les épaisseurs de couche des couches organiques sont dans la gamme de 0,1 nm à 50 µm.

12. Composant électroluminescent selon l'une quelconque des revendications 1 à 11, **caractérisé en ce que** les couches se composent de petites molécules vaporisées sous vide, ou se composent entièrement ou partiellement de polymères.

13. Composant électroluminescent selon l'une quelconque des revendications 1 à 12, **caractérisé en ce que** les couches mixtes sont formées au moyen d'une vaporisation mixte sous vide, d'un dépôt d'une couche mixte à partir d'une solution ou d'un dépôt successif des matières suivi d'une diffusion des dopants dans les couches.
